# EUROPEAN PATENT APPLICATION

(11) **EP 1 081 248 A2**
(43) Date of publication of application: **07.03.2001**
(21) Application number: 00307110.7
(22) Date of filing: 18.08.2000
(51) Int. Cl.: C23C 14/32, H01J 37/32

(54) **ARC type evaporation source**

(30) Priority: 18.08.1999 JP 23138499
(71) Applicant: NISSIN ELECTRIC COMPANY, LIMITED, Kyoto 615 (JP)
(72) Inventor: Okazaki, Naoto, Nissin Electric Co., Ltd., Kyoto-shi, Kyoto 615 (JP); Ohtani, Satoshi, Nissin Electric Co., Ltd., Kyoto-shi, Kyoto 615 (JP); Irisawa, Kazuhiko, Nissin Electric Co., Ltd., Kyoto-shi, Kyoto 615 (JP); Nakamura, Nobuhiko, Nissin Electric Co., Ltd., Kyoto-shi, Kyoto 615 (JP)
(74) Representative: Carpenter, David

(57) **Abstract**

An arc type evaporation source has a substantially columnar cathode which has an axial length larger than its diameter, a cathode feeding mechanism for feeding the cathode forward along the axis of the cathode, a cathode cooling mechanism for cooling at least a side surface of the cathode by coolant, and a magnetic coil for generating magnetic flux extending substantially perpendicularly to an evaporation surface of the cathode or extending outward from the evaporation surface.

## Description

### BACKGROUND OF THE INVENTION

### 1. Field of the Invention

The present invention relates to an arc type evaporation source for melting a cathode by arc discharge so as to evaporate cathode material. The evaporation source is used, for example, for forming a thin film composed of a cathode material or composed of a nitride, an oxide, etc. of the cathode material on the surface of a substrate of, for example, a tool, a mechanical part, a mold, an external cladding part, or the like, so that the substrate is improved in abrasion resistance, sliding property, anti-seizing property, decorativeness, and the like.

### 2. Description of the Related Art

Cathode material to be evaporated in an arc type evaporation source contains, at a considerable ratio, cathode material ions ionized by arc plasma generated near the cathode. In an arc ion plating method or an arc ion plating apparatus, such cathode material ions are led onto a substrate by an electric field so that a thin film is formed on the substrate surface. Accordingly, the arc ion plating method or the apparatus has advantages that the film-forming speed is high, the productivity is excellent, the adhesion of the thin film is high, and the like. The method or the apparatus has been used widely as means for coating a tool, a mold, or the like, with a metal film or a ceramic film.

The reason why the film-forming speed is high is that the cathode is melted by use of arc discharge so that a large quantity of cathode material can be evaporated. The reason why the adhesion of the film is high is that the cathode material ions contained in the cathode material are led onto the substrate by an electric field generated by negative bias voltage or the like so that the ions can collide with the substrate.

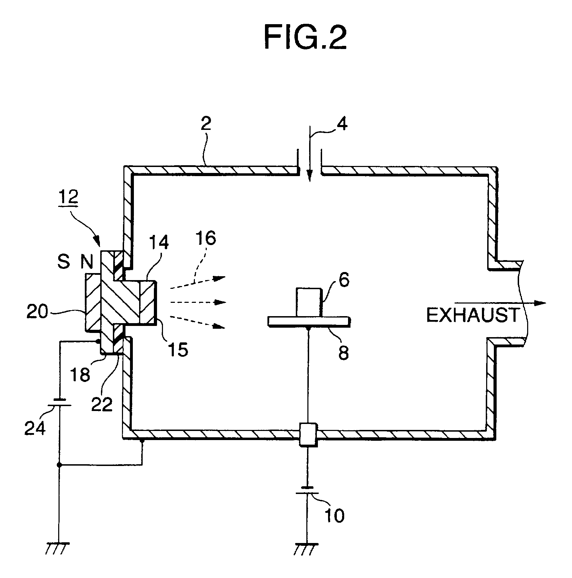

Fig. 2 shows an example of an arc ion plating apparatus having a conventional arc type evaporation source.

A holder 8 for holding a substrate 6 to be filmed is provided in a vacuum vessel 2 which is to be vacuum-pumped by a not-shown vacuum pump. A negative bias voltage which is, for example, approximately in a range of from about minus tens of volts to minus hundreds of volts is applied from a bias power supply 10 to the holder 8 and the substrate 6 held by the holder 8.

Gas 4 consisting of inert gas, reactive gas which is reactive with a cathode material 16 which will be described later, and the like, is introduced into the vacuum vessel 2.

A conventional arc type evaporation source 12 is attached to the wall surface of this vacuum vessel 2 so as to face the substrate 6 on the holder 8.

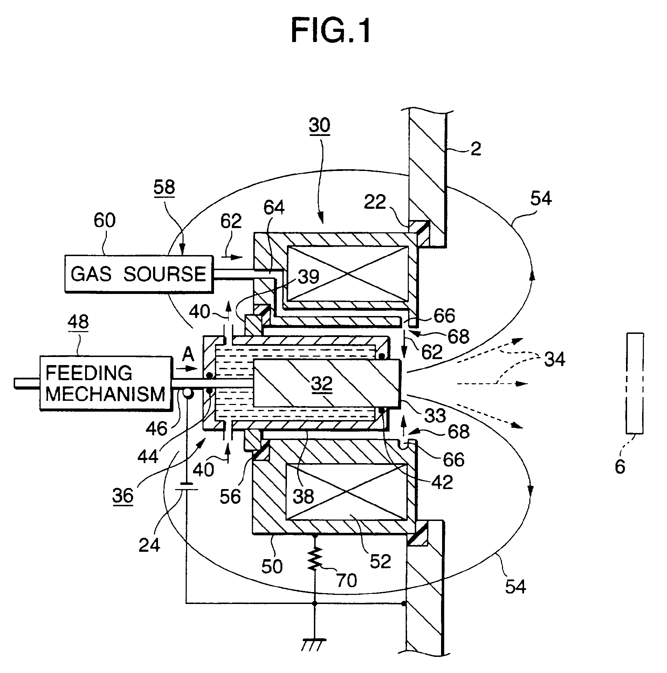

The arc type evaporation source 12 has a disc-like cathode 14 composed of a desired material. This cathode 14 is fixed to a cathode holder 18. The cathode holder 18 is usually provided with a water-cooling structure for cooling the cathode 14. In the rear vicinity of the cathode holder 18, there is provided apermanentmagnet 20 for controlling an arc spot on an evaporation surface 15 of the cathode 14. The cathode holder 18 is attached to the vacuum vessel 2 through an insulator 22. Incidentally, a trigger electrode for arc starting is usually provided, but its illustration is omitted here (similarly in Fig. 1).

In this conventional example, the vacuum vessel 2 serves also as an anode. An arc discharge voltage of, for example, about tens of volts is applied between the vacuum vessel 2 and the cathode holder 18, hence between the vacuum vessel 2 and the cathode 14, from the arc power supply 24 while the cathode 14 side is set to be a negative pole.

As a result, vacuum arc discharge is produced between the evaporation surface 15 of the cathode 14 and the vacuum vessel 2 so that the evaporation surface 15 is melted locally and the cathode material 16 is evaporated therefrom. Then, plasma is generated by the arc discharge in the front vicinity of the cathode 14 so that a part of the cathode material 16 is ionized. This cathode material 16 reaches the substrate 6 so as to be deposited thereon. Thus, a thin film is formed on the surface of the substrate 6. In that case, if reactive gas is introduced into the vacuum vessel 2 in advance, the cathode material 16 reacts with the reactive gas so that a compound thin film is formed on the surface of the substrate 6.

In the above-mentioned arc type evaporation source 12, it is necessary to exchange the cathode 14 for a new one in a predetermined cycle because the cathode 14 is consumed and shortened (thinned) gradually by arc discharge.

However, the conventional arc type evaporation source 12 has a disc-like shape which has an axial length shorter than its diameter (for example, 64 mm in diameter and 30 mm in length). Thus, the cathode 14 has to be exchanged frequently. Accordingly, it takes much labor to exchange the cathode 14, and the frequency of rest of a film-forming apparatus using this arc type evaporation source 12 increases so that the productivity is lowered.

Even if the cathode 14 is elongated in its axial direction simply, there arises problems as follows. That is, (1) it becomes insufficient to cool the evaporation surface 15 of the cathode 14 so that bulky melting portions are apt to be generated. (2) The state of magnetic flux on the evaporation surface 15 generated by the permanent magnet 20 changes largely with the consumption of the cathode 14 so that the consumption of the evaporation surface 15 is biased.

In addition, the life of the cathode 14 usually terminates when about 50 weight % of the cathode 14 has been consumed. Thus, the wasteful consumption of the cathode 14 is large. Particularly in the case where the cathode 14 is composed of expensive material such as Cr metal, a Ti-Al alloy, or the like, the waste is large in view of the cost.

In addition, with the consumption of the cathode 14, the evaporation surface 15 thereof retreats (that is, goes away from the substrate 6). Thus, the distance between the evaporation surface 15 and the substrate 6 changes so that the film-forming speed on the substrate 6 changes. As a result, the uniformity thickness of a film formed on the surface of the substrate 6 deteriorates. This deterioration arises in a short time.

### SUMMARY OF THE INVENTION

It is therefore an object of the present invention to provide an arc type evaporation source in which a cathode can be used effectively, the frequency of exchanging the cathode can be reduced, and the film-forming speed can be kept constant for a long time.

An arc type evaporation source according to the present invention comprises: a substantially columnar cathode in which an axial length is larger than a diameter; a cathode feeding mechanism for feeding said cathode forward along the axis of said substantially columnar cathode; a cathode cooling mechanism for cooling at least a side surface of said cathode by coolant; and a magnetic coil for generating magnetic flux in the vicinity of a surface of said cathode. Specifically, the magnetic coil generates magnetic flux extending substantially perpendicularly to an evaporatoin surface at a front end of the cathode or extending outward from the evaportion surface.

According to this arc type evaporation source, such magnetic flux is generated on the evaporation surface of the cathode by the magnetic coil so that the position of an arc spot can be limited within the evaporation surface of the cathode. In addition, the arc spot moves uniformly within the evaporation surface so that the evaporation surface can be consumed uniformly without any bias.

In addition, the cathode can be fed forward by the cathode feeding mechanism in accordance with the consumption of the cathode. As a result, even if the cathode is consumed, the state of the magnetic flux on the evaporation surface of the cathode can be kept substantially constant. This also contributes to the uniform consumption of the evaporation surface.

According to this arc type evaporation source, the substantially columnar cathode which has an axial length larger than its diameter (in other words, which is longer in the axial direction) can be consumed uniformly by the aforementioned operations, so that a large part of the cathode can be used effectively. Accordingly, the cathode can be used effectively and the frequency of exchanging the cathode can be reduced.

In addition, since the cathode can be fed forward by the cathode feeding mechanism in accordance with the consumption of the cathode, the distance between the evaporation surface and the substrate can be brought close to a fixed value. It is therefore possible to keep the film-forming speed constant for a long time.

Further, the cathode cooling mechanism is provided for cooling at least a side surface of the cathode by coolant. Accordingly, the evaporation surface of the cathode can be cooled effectively and stably without being affected by the consumption state of the cathode, even if the cathode has a columnar shape which is longer in its axial direction. As a result, the temperature of the evaporation surface is restrained from increasing, so that bulky particles (which are also called "droplets") can be prevented from being generated from the evaporation surface. It is therefore possible to form a thin film which is superior in surface roughness.

### BRIEF DESCRPTION OF THE DRAWINGS

In the accompanying drawings:
Fig. 1 is a sectional view showing an embodiment of an arc type evaporation source according to the present invention; and
Fig. 2 is a sectional view showing an example of an arc ion plating apparatus having a conventional evaporation source.

### PREFERRED EMBODINENT OF THE INVENTION

Fig. 1 is a sectional view showing an embodiment of an arc type evaporation source according to the present invention. Parts the same as or corresponding to those in the conventional one shown in Fig. 2 are referenced correspondingly. Different points in this embodiment from the conventional will be mainly described below.

In this embodiment, in use, an arc type evaporation source 30 is attached to the wall surface of a vacuum vessel 2 constituting an arc ion plating apparatus described previously so as to face a substrate 6. The reference numeral 22 represents an insulator described above.

The arc type evaporation source 30 has a substantially columnar cathode 32 which has an axial length larger than its diameter, a cathode feeding mechanism 48 for feeding the cathode 32 forward along the axis of the cathode 32 (that is, toward the substrate 6) as shown by the arrow A, a cathode cooling mechanism 36 for cooling at least a side surface of the cathode 32 by coolant 40, and a magnetic coil 52 for generating magnetic flux 54 extending substantially perpendicularly to an evaporation surface 33 at the front end of the cathode 32 or extending outward from the evaporation surface 33.

Incidentally, members near the magnetic coil 52 are composed of nonmagnetic material so as not to disturb the magnetic flux 54 generated by the magnetic coil 52.

The cathode 32 is composed of desired material (for example, metal, an alloy, carbon, or the like) in accordance with the kind of a film to be formed. Specifically, the cathode 32 is composed of, for example, metal such as Ti, Cr or the like; an alloy such as Ti-Al or the like; carbon (C); etc.

The cathode 32 is supported on a front end portion of a support shaft 46 in this embodiment. The cathode 32 is fed forward through this support shaft 46 by the cathode feeding mechanism. The cathode feeding mechanism 48 is not limited to what has a specific structure, and it may be of a hand-operated one or a power-operated one. For example, it may be a hand-operated mechanism in which a handle is attached to a ball nut which is to be screwed down to a ball screw formed in a part of the support shaft 46.

Electric power is supplied from the above-mentioned arc power supply 24 to the cathode 32 through the support shaft 46 in this embodiment.

In this embodiment, the cathode cooling mechanism 36 has a cathode receiving vessel 38 for receiving the cathode 32 in the state where the evaporation surface 33 of the cathode 32 is exposed to the outside. Coolant 40 is made to flow into the cathode receiving vessel 38. In this embodiment, the side surface and the bottom surface (opposite to the evaporation surface 33) of the cathode 32 can be cooled by this coolant 40. In the portions where the cathode 32 and the support shaft 46 penetrate the cathode receiving vessel 38, packings 42 and 44 are provided for preventing the coolant 40 from leaking. In this embodiment, the cathode receiving vessel 38 is attached to a coil receiving vessel 50, which will be described later, through a flange 39 and an insulator 56.

The magnetic coil 52 is wound around the cathode 32. The magnetic coil 52 is excited by a not-shown DC power supply. The magnetic flux 54 in Fig. 1 shows an example of magnetic flux generated by the magnetic coil 52. The magnetic coil 52 is received in the coil receiving vessel 50 in this embodiment. The coil receiving vessel 50 is attached to the above-mentioned vacuum vessel 2 through the above-mentioned insulator 22 in this embodiment.

In this embodiment, a resistor 70 is provided between the coil receiving vessel 50 and the vacuum vessel 2 connected to the ground. This resistor 70 prevents arc discharge from occurring between the cathode 32 and the coil receiving vessel 50. Thus, the resistor 70 operates to extend the arc, that is, to produce arc discharge between the cathode 32 and the vacuum vessel 2 which is at a certain distance from the cathode 32.

Further in this embodiment, there is provided a gas blowing mechanism 58 for blowing reactive gas 62 onto the vicinity of the evaporation surface 33 of the cathode 32. The reactive gas 62 is reactive with the material composing the cathode 32 so as to produce a compound.

In this embodiment, the gas blowing mechanism 58 has a gas source 60 for supplying the reactive gas 62, a gas channel 64 provided to pass through the coil receiving vessel 50 so as to introduce the reactive gas 62, a ring-like portion 66 connected to this gas channel 64 and provided in the coil receiving vessel 50 so as to enclose the vicinity of the evaporation surface 33 of the cathode 32, and a plurality of gas outlets 68 dispersed substantially uniformly in this ring-like portion 66. For example, the reactive gas 62 contains nitrogen, carbon, oxygen, or the like. More specifically, the reactive gas 62 may be nitrogen gas.

This arc type evaporation source 30 also generates arc discharge between the evaporation surface 33 of the cathode 32 and the vacuum vessel 2 so that the evaporation surface 33 can be melted locally by this arc discharge. Thus, the cathode material 34 ionized partially can be evaporated from the evaporation surface 33. As a result, a thin film composed of the cathode material 34 or a thin film composed of a compound produced by the reaction between the cathode material 34 and reactive gas (for example, the reactive gas 62) can be formed on the surface of the substrate 6 disposed in front of the evaporation surface 33.

Further, this arc type evaporation source 30 has the substantially columnar cathode 32 which has an axial length larger than its diameter (in other words, longer in the axial direction). Not only is the cathode 32 formed into a columnar shape longer in the axial direction, but also the cathode feeding mechanism 48 is provided for feeding the cathode 32 forward, the cathode cooling mechanism 36 for cooling at least a side surface of the cathode 32, and the magnetic coil 52 for generating the above-mentioned magnetic flux 54 on the evaporation surface 33 of the cathode 32. As a result, it is possible to use the cathode 32 effectively and hence reduce the frequency of exchanging the cathode. In addition, it is possible to keep the film-forming speed constant for a long time.

Describingindetail, accordingtothearctypeevaporation source 30, the above-mentioned magnetic flux 54 is generated on the evaporation surface 33 of the cathode 32 by the magnetic coil 52 so that the position of an arc spot of arc discharge can be limited within the evaporation surface 33 of the cathode 32. In addition, the arc spot moves uniformly within the evaporation surface 33 so that the evaporation surface 33 can be consumed uniformly without any bias from the beginning to the end while the cathode 32 is in use.

Moreover, the cathode 32 can be fed forward by the cathode feeding mechanism 48 in accordance with the consumption of the cathode 32. As a result, even if the cathode 32 is consumed, the magnetic flux 54 on the evaporation surface 33 of the cathode 32 can be kept substantially constant in the same state as at the beginning. This also contributes to the uniform consumption of the evaporation surface 33.

According to this arc type evaporation source 30, the substantially columnar cathode 32 which is longer in axial length can be consumed uniformly by the aforementioned operations, so that most of the cathode can be used effectively at a higher rate than that in the conventional. For example, about 80 weight % of the cathode 32 can be used effectively as in the example which will be described later. Accordingly, the cathode 32 can be used effectively and the frequency of exchanging the cathode 32 can be reduced.

As a result, the labor to exchange the cathode 32 can be reduced because the frequency of exchanging the cathode 32 can be reduced. In addition, the frequency of rest of a film-forming apparatus using this arc type evaporation source 30 is reduced so that the productivity is improved. Further, the waste of the cathode 32 is reduced so that the cost required for the cathode can be reduced. Particularly, in the case where the cathode 32 is composed of expensive material such as Cr metal, a Ti-Al alloy, or the like, there is a large effect on reduction in the cost required for the cathode.

In addition, since the cathode 32 can be fed forward by the cathode feeding mechanism 48 in accordance with the consumption of the cathode 32, the distance between the evaporation surface 33 and the substrate 6 can be brought close to a fixed value. It is therefore possible to keep the film-forming speed constant for a long time. As a result, the reproducibility of the film-forming speed is improved, and the uniformity of the thickness of the film formed on the substrate 6 is also enhanced.

Further, the cathode cooling mechanism 36 is provided for cooling at least a side surface of the cathode 32 by the coolant 40. Accordingly, the evaporation surface 33 of the cathode 32 can be cooled effectively and stably without being affected by the consumption state of the cathode 32, even if the cathode 32 has a columnar shape which is longer in axial direction. As a result, the temperature of the evaporation surface 33 is restrained from increasing, so that bulky particles (droplets) can be prevented from being generated from the evaporation surface 33. Therefore, a thin film which is superior in surface roughness (that is, fine in the film surface and excellent in smoothness) can be formed on the surface of the substrate 6.

When the above-mentioned gas blowing mechanism 58 is provided as in this embodiment, arc discharge can be generated while the reactive gas 62 is blown onto the vicinity of the evaporation surface 33 of the cathode 32. As a result, the reactive gas 62 reacts with the material composing the cathode 32 so that a compound which has a higher melting point than that of the original cathode material is formed on the evaporation surface 33. Thus, a large number of cathode spots (arc spots) for arc discharge are formed on the evaporation surface 33 so that an arc current is shared among the large number of cathode spots. As a result, the cathode material 34 evaporated from the individual cathode spots is made so fine that bulky particles can be more effectively restrained from being produced. It is therefore possible to form a thin film which is more excellent in surface roughness.

### Example

The arc type evaporation source 30 having a configuration with the cathode 32, which was composed of Cr and was 64 mm in diameter and 150 mm in axial length, was attached to an arc ion plating apparatus shown in Fig. 2, and a process of film-forming was performed. High speed tool steel was used for the substrate 6. That is, after the vacuum vessel 2 was vacuum-pumped to the extent of about 5 × 10⁻⁵ Torr, 200 sccm of nitrogen gas was supplied as the reactive gas 62 from the gas blowing mechanism 58, so that the pressure in the vacuum vessel 2 was kept to be about 20 mTorr. In this state, arc discharge was generated in the arc type evaporation source 30 so that a process of film-forming was performed while an arc current of about 150A was kept. At this time, a bias voltage of -200 V was applied to the substrate 6. Thus, a film 2 µm thick per hour could be formed. The cathode 32 was fed forward by 2 mm every time when a process of 3 µm thick film-forming on the substrate 6 was performed three times.

As a result, about 80 weight % of the cathode 32 could be used satisfactorily. In addition, the arc type evaporation source 30 could be operated for a period which was about ten times as long as that in the arc type evaporation source 12 having a conventional structure with the disc-like fixed cathode 14 whichwas 64 mm in diameter and 30 mm in axial length. In addition, during the period, the film-forming speed could be kept substantially constant.

Since the present invention is configured as described above, it has effects as follows.

According to the present invention, an arc type evaporation source has a substantially columnar cathode which has an axial length larger than its diameter. Not only is the cathode formed into a columnar shape longer in the axial direction, but also there are provided a cathode feeding mechanism for feeding the cathode forward, a cathode cooling mechanism for cooling at least a side surface of the cathode, and a magnetic coil for generating magnetic flux on an evaporation surface of the cathode. As a result, it is possible to use the cathode effectively and hence reduce the frequency of exchanging the cathode. In addition, it is possible to keep the film-forming speed constant for a long time.

As a result, the labor to exchange the cathode can be reduced because the frequency of exchanging the cathode can be reduced. In addition, the frequency of rest of a film-forming apparatus using this arc type evaporation source is reduced so that the productivity is improved. Further, the waste of the cathode is reduced so that the cost required for the cathode can be reduced. In addition, since the film-forming speed can be kept constant for a long time, the reproducibility of the film-forming speed is improved, and the uniformity of the thickness of a film formed on a substrate is also enhanced.

Further, since the cathode cooling mechanism is provided for cooling at least a side surface of the cathode by coolant, the evaporation surface of the cathode can be cooled effectively and stably without being affected by the consumption state of the cathode, even if the cathode has a columnar shape which is longer in the axial direction. As a result, the temperature of the evaporation surface is restrained from increasing, so that bulky particles can be prevented from being generated from the evaporation surface. It is therefore possible to form a thin film which is more excellent in surface roughness.

Further, according to the present invention, an arc type evaporation source further has a gas blowing mechanism. As a result, bulky particles can be more effectively restrained from being generated from an evaporation surface of a cathode. It is therefore possible to form a thin film which is more excellent in surface roughness.

## Claims

1. An arc type evaporation source for melting a cathode by arc discharge so as to evaporate cathode material, comprising:
a substantially columnar cathode having an axial length larger than its diameter;
a cathode feeding mechanism for feeding said cathode forward along the axis of said cathode;
a cathode cooling mechanism for cooling at least a side surface of said cathode by coolant; and
a magnetic coil for generating magnetic flux in the vicinity of a surface of said cathode.

2. The arc type evaporation source according to claim 1, further comprising a gas blowing mechanism for blowing reactive gas onto the vicinity of said evaporation surface of said cathode, said reactive gas reacting with material composing said cathode so as to produce a compound.

3. The arc type evaportion source according to claim 1, wherein members near said magnetic coil comprises nonmagnetic material so as not to disturb the magnetic flux generated by said magnetic coil.

4. The arc type evaportion source according to claim 1, wherein the magnetic coil generates magnetic flux extending substantially perpendicularly to an evaporatoin surface at a front end of the cathode or extending outward from the evaportion surface.
